# EUROPEAN PATENT APPLICATION

(11) **EP 2 657 982 A1**
(43) Date of publication of application: **30.10.2013**
(21) Application number: 11851806.7
(22) Date of filing: 19.12.2011
(51) Int. Cl.: H01L 31/042

(54) **PRODUCTION METHOD FOR SOLAR CELL MODULE, AND SOLAR CELL MODULE**

(30) Priority: 22.12.2010 JP 2010286561
(71) Applicant: Dexerials Corporation, Tokyo 141-0032 (JP)
(72) Inventor: HIGUCHI, Akifumi, Tokyo 141-0032 (JP); OKUMIYA, Hideaki, Tokyo 141-0032 (JP); SUGA, Yasuhiro, Tokyo 141-0032 (JP)
(74) Representative: Müller - Hoffmann & Partner
(86) International application number: PCT/JP2011/079370
(87) International publication number: WO 2012/086590

(57) **Abstract**

The present invention suppresses sealing resin to protrude outside a surface protective member or rear surface protective member. Furthermore, the present invention provides a solar cell module that can achieve higher output and is excellent in long-term reliability. The present invention includes a plurality of solar cells (2), and when a solar cell module (1) is produced by connecting between the solar cells (2) with a tab wire (6) that is connected via an adhesive layer (7) to connection electrodes (4, 5), and by sealing with a surface protective member (12) on the light-receiving surface side and a rear surface protective member (13) on the rear surface side via first and second sealing resin layers (10, 11), which are arranged on the light-receiving surface side and on the rear surface side of the plural solar cells (2), the plural solar cells (2) are sealed by the surface protective member (12) and the rear surface protective member (13) through the first and second sealing resin layers (10, 11) in which the ratio (B/A) of the thickness (A) of the tab wire (6) and the thickness (B) of the respective first sealing resin layer (10) and second sealing resin layer (11) is 1.4 to 3.0 using the tab wire (6) with a thickness of 0.2 mm to 0.4 mm.

## Description

### Field of the Invention

This invention relates to a method for producing a solar cell module in which electrodes for use in connecting a plurality of solar cells are connected with one after another with tab wires, and such a solar cell module.

The present application asserts priority rights based on JP Patent Application 2010-286561 filed in Japan on December 22, 2010. The total contents of disclosure of the Patent Application of the senior filing date are to be incorporated by reference into the present Application.

### Background of the Invention

Since a solar cell makes it possible to directly convert solar light that is a clean, limitless energy source into electricity, it has drawn public attentions as a new energy source that is environmentally friendly. Upon using the solar cell as a power source, since the output per single solar cell is about several Watts, not each of the solar cells is used, but a plurality of solar cells, which are connected in series with one another to increase the output to 100 Watts or more, are used as a solar cell module.

In a crystal silicon-based solar cell module, a plurality of adjacent solar cells are connected to one after another by tab wires, each made of a ribbon-shaped copper foil or the like that is solder-coated. In the solar module, each tab wire has its one end connected to a surface electrode of a solar cell, with the other end being connected to the rear surface electrode of an adjacent solar cell, so that the respective solar cells are series-connected to one after another.

More specifically, the solar cell and the tab wire are connected to each other by connecting a busbar electrode formed on the light-receiving surface of the solar cell by a screen printing process of a silver paste, as well as an Ag electrode formed on a rear surface connection portion of the solar cell, with the tab wire through a soldering process. Additionally, on the region other than the connection portion of the rear surface of the solar cell, Al electrodes are formed. A plurality of the solar cells are covered with a surface cover on the busbar electrode side, with a sealing resin sheet being interpolated therebetween, and also covered with a back sheet on the rear surface electrode side, with a sealing resin sheet being interpolated therebetween, so as to be protected.

However, in the case of soldering, since the connection process is carried out at a high temperature such as about 260°C, there might be a problem with connection reliability between the busbar electrode as well as the rear surface electrode of the solar cell and the tab wire, due to a warp of the solar cell and an inner stress caused in the connection portion between the tab wire and the busbar electrode as well as the rear surface electrode. Moreover, the soldering process tends to cause a problem in that when a solder flow-out occurs, the light-receiving area is contracted.

In this case, in the solar module, a wire having a thickness in a range from 0.1 mm to 0.2 mm is used as the tab wire. However, in the case of the tab wire having a thin thickness, the output of a solar cell module is lowered due to an electric resistance value of the tab wire itself. In contrast, in the case when the thickness of the tab wire is increased, since the electric resistance value of the tab wire itself is lowered, a stress caused thereon due to expansion/contraction of the tab wire at the time of application of heat is increased, although the improvement of the output of the solar module is achieved. For this reason, in the soldering process, cracks in the solar cell and peeling of the tab wire tend to occur at the time of the connection process of the tab wire, possibly resulting in a reduction in the long-term reliability,

As a connection method between the tab wire and the busbar electrode as well as the rear surface electrode, a method has been proposed in which a conductive adhesive film, which can be connected by a thermal press-bonding process at a temperature lower than that of the soldering process, is used (for example, see Patent Document 1). As such a conductive adhesive film, spherical or scale-shaped conductive particles having an average particle diameter in the order of several µ ms are dispersed in a thermosetting-type binder resin composition, and this is formed into a film, and used.

Since the temperature at the time of the connection process is low, this connection method using such a conductive adhesive film makes it possible to prevent problems in which the connection reliability between the electrode and the tab wires deteriorates due to a warp of the solar cells and peeling of the tab wire from the electrode. Moreover, this method is desirable because, different from solder plating, no shrinkage of the light-receiving area is caused.

Moreover, in the case of the connection method using a conductive adhesive film, since the temperature at the time of the connection process is low, this method is free from cracks in the solar cells as well as peeling of the tab wire that tend to be caused at the time of connection of tab wires using solder plating or the like, even when the thickness of the tab wire is made thicker.

However, in the case when the thickness of the tab wire is made thicker, the thickness of sheets, made of a sealing resin, that are placed on the light-receiving surface and the rear surface, and interpolated between the plural solar cells and the surface cover as well as the back sheet also becomes thicker. For this reason, upon laminating the solar cells as one lot, while being sandwiched between the surface cover and the back sheet via sheets, a problem is raised in that one portion of the sealing resin forming the sheet tends to protrude onto the peripheral portion of the surface cover and the back sheet. Moreover, another problem might be raised in that the solar cells are damaged due to a thermal stress caused by temperature changes.

### Prior-Art Documents

### Patent Document

PTL 1: Japanese Patent Application Laid-Open No. 2008-147567

### Summary of the Invention

In view of these conventional circumstances, the present invention has been devised, and an object of the present invention is to provide a method for producing a solar cell module and such a solar cell module that can suppress one portion of a sealing resin from protruding onto the peripheral portion of a surface protective member and a rear surface protective member even when the thickness of the tab wire is made thicker, and achieves a high output, with superior long-term reliability being also achieved.

A method for producing a solar cell module according to the present invention that achieves the above-mentioned object relates to the method for producing a solar cell module provided with a plurality of solar cells, each provided with a surface electrode formed on a light-receiving surface side and a rear surface electrode formed on a rear surface on a side opposite to the light-receiving surface; tab wires each of which is connected to the surface electrode of one of the solar cells and also to the rear surface electrode of another solar cell that is adjacent to the one of the solar cells through an adhesive agent so that the plural solar cells are connected to one after another; and the plural solar cells that are electrically connected to one after another with the tab wires are sealed by a surface protective member formed on the light-receiving surface side and a rear surface protective member formed on the rear surface side through a first sealing resin layer formed on the light-receiving surface side and a second sealing resin layer formed on the rear surface side, and in this method, the tab wires, each having a thickness (A) in a range from 0.2 mm to 0.4 mm, are formed on the surface electrode and the rear surface electrode of each solar cell through an adhesive agent layer, and by thermally press-bonding the tab wires on the adhesive agent layer so that the surface electrode and the rear surface electrode are connected to the tab wires, and the plural solar cells are sealed by the surface protective member and the rear-surface protective member through a first sealing resin layer and a second sealing resin layer in which a ratio (B/A) of the thickness (A) of the tab wire to a thickness (B) of each of the layers of the first sealing resin layer and the second sealing resin layer is set in a range from 1.4 to 3.0.

A solar cell module in accordance with the present invention that achieves the above-mentioned object is provided with: a plurality of solar cells, each provided with a surface electrode formed on a light-receiving surface side and a rear surface electrode formed on a rear surface on a side opposite to the light-receiving surface; tab wires each of which electrically connects the surface electrode of one of the solar cells to the rear surface electrode of another solar cell that is adjacent to the one of the solar cells; an adhesive agent layer that connects the surface electrode and the rear surface electrode with the tab wire; a first sealing resin layer formed on the light-receiving surface side and a second sealing resin layer formed on the rear surface side that seal the plural solar cells that are electrically connected to one after another with the tab wires; and a surface protective member and a rear surface protective member respectively formed outside the first sealing resin layer and the second sealing resin layer so as to protect the solar cells, and in this structure, each of the tab wires has a thickness (A) in a range from 0.2 mm to 0.4 mm; and a ratio (B/A) of the thickness (A) of the tab wire to a thickness (B) of each of the layers of the first sealing resin layer and the second sealing resin layer is set in a range from 1.4 to 3.0.

In the present invention, each of the tab wires that connects the surface electrode of one of the solar cells to the rear surface electrode of another solar cell that is adjacent to the one of the solar cells via the adhesive agent layer has a thickness (A) in a range from 0.2 mm to 0.4 mm, and by carrying out a sealing process by using the surface protective member and the rear surface protective member, with the first sealing resin layer and the second sealing resin layer, which provides a ratio (B/A) of the thickness (A) of the tab wire to a thickness (B) of each of the layers of the first sealing resin layer and the second sealing resin layer is set in a range from 1.4 to 3.0, interpolated therebetween so that it is possible to provide good reliability and also to suppress one portion of the resin forming the first sealing resin layer and the second sealing resin layer from protruding onto the peripheral portion of the surface protective member and the rear surface protective member.

### Brief Description of Drawings

Figure 1 is an exploded perspective view showing a structure of a solar cell module in accordance with a first embodiment to which the present invention is applied.
Figure 2 is a cross-sectional view showing strings of a solar cell.
Figure 3 is a partial cross-sectional view that shows a relationship between a tab wire and the thicknesses of a first sheet and a second sheet in the solar cell module.
Figure 4 is a cross-sectional view showing a conductive adhesive film.
Figure 5 is a partial cross-sectional view that shows a relationship between a tab wire and the thicknesses of a first sheet and a second sheet of a solar module in accordance with a second embodiment to which the present invention is applied.
Figure 6 is a perspective view that shows a tab wire for use in connecting the solar cells.
Figure 7 is a cross-sectional view that shows scattering of incident light onto the solar cell module.
Figure 8 is a partial cross-sectional view that shows a relationship between a tab wire and the thicknesses of a first sheet and a second sheet of a solar cell module in accordance with a third embodiment to which the present invention is applied.
Figure 9 is a perspective view of a tab wire for use in connecting the solar cells.

### Detailed Description of the Invention

Referring to Figures, the following description will discuss a production method for a solar cell module to which the present invention is applied, and such a solar cell module in detail. As the solar cell module to which the present invention is applied, various modules, such as a crystal silicon-based solar cell module using a single crystal-type silicon photoelectric conversion element or a polycrystal-type photoelectric conversion element as its photoelectric conversion element, and a thin-film silicon-based solar cell using a photoelectric conversion element in which a cell made of amorphous silicon and a cell made of microcrystal silicon and amorphous silicon germanium are stacked on each other, may be used.

### [First Embodiment]

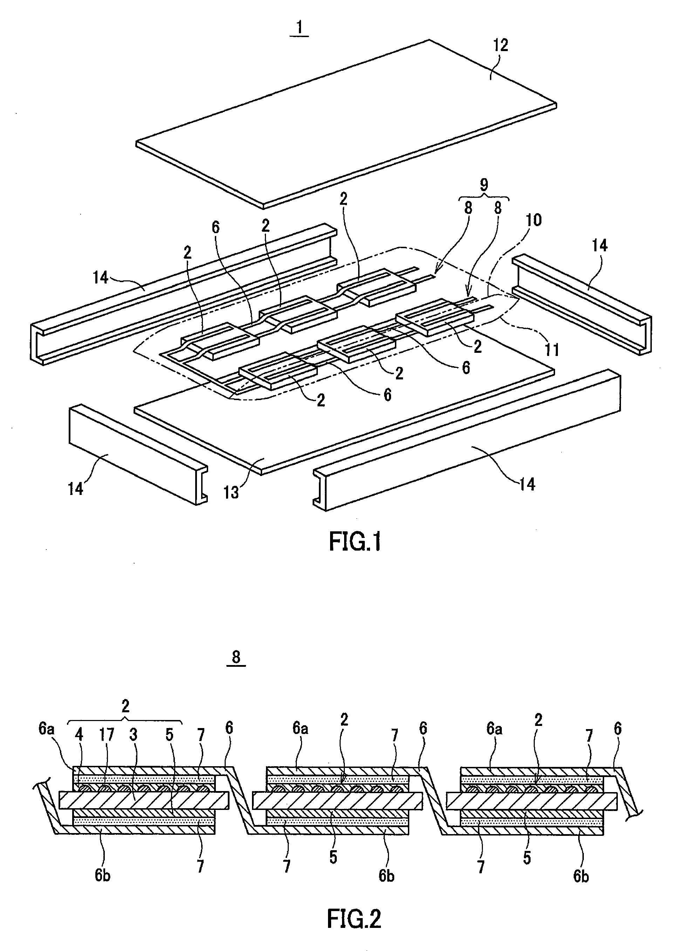

Fig. 1 is an exploded perspective view showing a solar cell module in accordance with a first embodiment to which the present invention is applied. As shown in Figs. 1 and 2, a solar cell module 1 is provided a plurality of solar cells 2, and tab wires 6 serving as interconnectors are connected to busbar electrodes 4 and a rear surface electrode 5 formed on a photoelectric conversion element 3 of each of the solar cells 2 through a conductive film 7 so that a string 8 in which the plural solar cells 2 are connected in series with one after another is prepared. The solar cell module 1 is provided with a matrix 9 in which a plurality of these strings 8 are arranged. Moreover, the solar module 1 is formed through processes in which a surface cover 12 to form a surface protective member formed on the light-receiving surface side and a back sheet 13 to form a rear surface protective member formed on the rear surface side are laminated onto the matrix 9 as one lot, with a first sheet 10 to form a first sealing resin layer and a second sheet 11 to form a second sealing resin layer being respectively interpolated therebetween, and a metal frame 14 such as aluminum or the like is attached onto the peripheral portion.

Prior to detailed descriptions of the respective structures of the solar cell module 1, first, a production method for the solar cell module 1 will be explained. In the production method for the solar cell module 1, first, the string 8 in which the plural solar cells 2 are series-connected to one after another is produced.

In the production method for the string 8, first, an uncured conductive adhesive film 7 is temporarily pasted onto the busbar electrodes 4 and the rear surface electrode 5 of each of the solar cells 2. Upon carrying out the temporarily pasting process, by conducting a heating process at such a temperature (for example, 40 to 70°C) as to cause flowability in the conductive adhesive film 7, but not to cause an actual curing operation, for a predetermined period of time (for example, 0.5 to 5 seconds) so that the conductive adhesive film 7 is temporarily pasted onto the busbar electrodes 4 and the rear surface electrode 5. Then, the solar cells 2, each having the conductive adhesive film 7 temporarily pasted thereon, are arranged in an order to be series-connected.

Next, a tab wire 6 is temporarily press-bonded on the conductive adhesive film 7 temporarily pasted onto the busbar electrodes 4 and the rear surface electrode 5 of each of the arranged solar cells 2. As shown in Fig. 2, the temporarily press-bonding process is carried out in the following manner: Onto the busbar electrodes 4 formed on the surface of each solar cell 2, one of end portions 6a of the tab wire 6 is temporarily press-bonded, with an uncured conductive adhesive film 7 being interpolated therebetween. Then, onto the rear surface electrode 5 of another succeeding solar cell 2, the other end portion 6b of the tab wire 6 is temporarily press-bonded, with an uncured conductive adhesive film 7 being interpolated therebetween. In the same manner, the tab wires 6 are temporarily press-bonded onto the adjacent solar cells 2 so that the plural solar cells 2 are coupled to one after another with the tab wires 6 that are temporarily press-bonded thereon.

The temporarily press-bonding process of the tab wires 6 is carried out by conducting a heating process at such a temperature (for example, 40 to 70°C) as not to allow the hardening reaction of the conductive adhesive film 7 to progress, and the tab wire 6 is compressed onto the busbar electrodes 4 and the rear surface electrode 5 for a predetermined period of time (for example, 0.5 to 5 seconds.

Next, the tab wire 6 is actually press-bonded onto the busbar electrodes 4 and the rear surface electrode 5. In the actual press-bonding process, the tab wire 6 is heated and compressed onto the busbar electrodes 4 and the rear surface electrode 5 of each solar cell 2 so that the conductive adhesive film 7 is hardened; thus, the tab wire 6 is actually press-bonded onto the busbar electrodes 4 and the rear surface electrode 5. In this case, the heating temperature corresponds to a temperature at which the conductive adhesive film 7 is hardened. By this actual press-bonding process, the binder resin of the conductive adhesive film 7 is thermally hardened so that the busbar electrodes 4, the rear surface electrode 5 and the tab wire 6 are connected to one after another electrically as well as mechanically; thus, the string 8 is produced by series-connecting the adjacent solar cells 2 to each other.

In this production method for the string 8, since the busbar electrodes 4, the rear surface electrode 5 and the tab wire 6 are connected to one another by the conductive adhesive film 7, either of Al and Ag may be used as the rear surface electrode 5 of each solar cell 2; however, by using a rear surface Al collector electrode as the rear surface electrode 5, it becomes not necessary to prepare a conventionally-used Ag electrode for use in solder connection; therefore, the production process of the solar cell can be shortened, and this method is advantageous from the production engineering point of view.

Next, the matrix 9 on which the plural strings 8 are arranged, produced as described above, is sealed with the first sheet 10, the second sheet 11, the surface cover 12 and the back sheet 13. More specifically, as shown in Fig. 1, from the light-receiving surface side, the surface cover 12 made of glass or the like, the first sheet 10 made of an ethylene vinyl acetate resin or the like, the matrix 9, the second sheet 11 made of an ethylene vinyl acetate resin or the like, and the back sheet 13 are stacked in this order, and after having been evacuated into vacuum, a laminating process is carried out at 130 to 150°C for 2 to 5 minutes. Then, by heating this at 130 to 150°C for 15 to 30 minutes, the binder resin is completely hardened. Thereafter, a metal frame 14 and a terminal box, not shown, are attached thereto so that a solar cell module 1 can be obtained.

In the case when the above-mentioned solar module 1 is produced, a wire having a thickness (A) of 0.2 mm to 0.4 mm is used as the tab wire 6, and as the first sheet 10 to form the first sealing resin layer and the second sheet 11 to form the second sealing resin layer, each sheet having a thickness (B) that provides a ratio of thicknesses (B/A) relative to the thickness of the tab wire 6 in a range from 1.4 to 3.0 is used so as to carry out the sealing process.

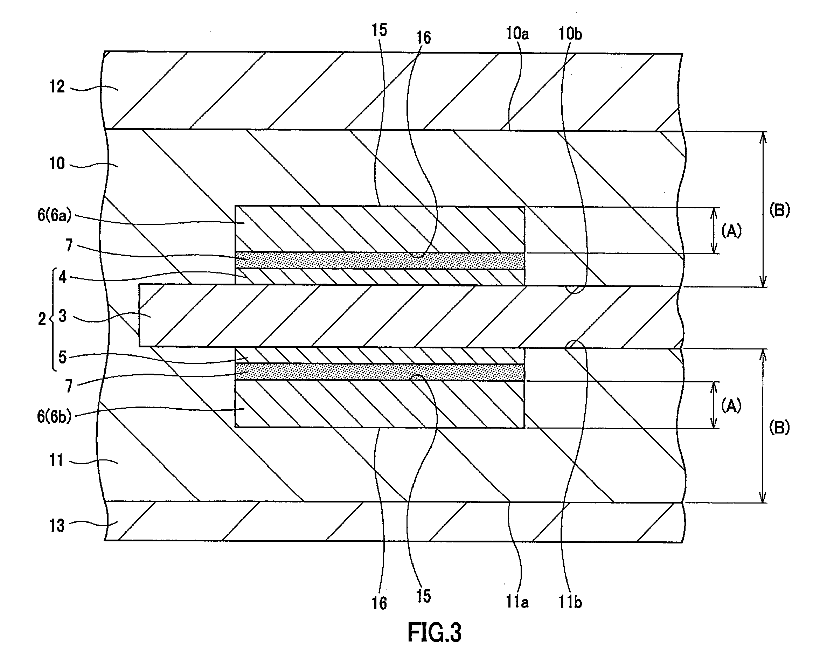

More specifically, upon sealing the matrix 9 with the first sheet 10 and the second sheet 11, as shown in Fig. 3, the first sheet 10 and the second sheet 11, which set the ratio (B/A) of the thickness (A) of the tab wire 6 relative to the thickness (B) of each of the first sheet 10 and the second sheet 11 in a range of 1.4 to 3.0, are used.

In this case, the thickness (A) of the tab wire 6 refers to a distance from one of the surfaces 15 of the tab wire 6 to the other surface 16 thereof. Additionally, in the case when the tab wire 6 is plated, the thickness refers to only a thickness of the copper foil portion without including the plated portion. The thickness (B) of the first sheet 10 refers to a distance from one of surfaces 10a on the surface cover 12 side to the other surface 10b thereof on the photoelectric conversion element 3 side. The thickness (B) of the second sheet 11 refers to a distance from one of surfaces 11a on the back sheet 13 side to the other surface 11b on the photoelectric conversion element 3 side.

In the production method for the solar module 1, by setting the ratio of thicknesses (B/A) to 3.0 or less, even when the first sheet 10 is compressed by the surface cover 12 at the time of the laminating process, or even when the second sheet 11 is compressed by the back sheet 13 at that time, it becomes possible to prevent one portion of the resin forming the first sheet 10 or the second sheet 11 from protruding onto the peripheral portion of the surface cover 12 and the back sheet 13.

Moreover, in the production method for the solar cell module 1, by setting the ratio of thicknesses (B/A) to 1.4 or less, it is possible to prevent the thicknesses of the first sheet 10 and the second sheet 11 from becoming too thin, thereby preventing bubbles from remaining in the first sheet 10 and the second sheet 11.

In the solar cell module 1 produced by the above-mentioned production method for the solar cell module 1, by setting the ratio (B/A) of the thickness (A) of the tab wire 6 relative to the thickness (B) of each of the first sheet 10 and the second sheet 11 stacked on the tab wire 6 to 1.4 or more, even when the tab wire 6 is expanded/contracted due to heat, a stress caused by the expansion/contraction of the tab wire 6 is absorbed by the first sheet 10 and the second sheet 11 so that it becomes possible to prevent peeling from occurring in the tab wire 6 and also to prevent cracks from occurring in the solar cell 2, thereby making it possible to prevent a reduction of the power generation efficiency.

Moreover, in this production method for the solar cell module 1, a wire having a thickness (A) of 0.2 mm to 0.4 mm is used as the tab wire 6, and by using the first sheet 10 and the second sheet 11 that make a ratio of thicknesses (B/A) set to 1.7 to 2.0, it becomes possible to prevent one portion of the resin forming the first sheet 10 and the second sheet 11 from protruding from the peripheral portion of the surface cover 12 and the back sheet 13 at the time of a laminating process, to prevent peeling of the tab wire 6, and also to prevent cracks from occurring in the solar cell 2; thus, the power generation efficiency can be prevented from being lowered.

### [Respective Configurations of Solar Cell Module]

Next, the following description will discuss respective configurations of the solar cell module 1. As described above, the solar cell module 1 is provided with a plurality of solar cells 2.

On the light-receiving surface of a photoelectric conversion element 3 of each of the solar cells 2, busbar electrodes 4 serving as surface electrodes, finger electrodes 17 serving as collector electrodes that are formed in a direction virtually orthogonal to the busbar electrodes 4 are formed. Moreover, on a rear surface on the side opposite to the light-receiving surface of the photoelectric conversion element 3, a rear surface electrode 5 made of aluminum, silver or the like is installed.

The busbar electrodes 4 are formed by applying an Ag paste onto the photoelectric conversion element 3, and by heating this thereon. In order to make an area that shields incident light smaller and consequently to suppress a shadow loss, the busbar electrodes 4 are formed on the light-receiving surface of the solar cell 2 as lines having, for example, a width of 1 mm. The number of busbar electrodes 4 is appropriately set on demand by taking into consideration the size of the solar cell 2, a resistance value thereof, and the like.

The finger electrodes 17 are formed over virtually the entire surface of the light- receiving surface of the solar cell 2 in a manner so as to intersect the busbar electrodes 4 by using the same method as that of the busbar electrodes 4. Moreover, the finger electrodes 17 are formed as lines, each having, for example, a width of about 100µ m, that have predetermined intervals, for example, every other 2 mm.

The rear surface electrode 5 is an electrode made of aluminum, silver or the like, and formed on the rear surface of the photoelectric conversion element 3 by using, for example, a screen printing method, a sputtering method, or the like.

As the tab wires 6, tab wires having a thickness higher than that of the tab wires that have been used in a conventional solar cell module are used. The thickness of the tab wires 6 is in a range of 0.2 mm to 0.4 mm. Each tab wire 6 is formed by using a ribbon-shaped copper foil, with a gold plating, silver plating, tin plating, solder plating process or the like being carried out thereon, if necessary. In the case when plating is applied onto the copper foil to form the tab wire 6, a drum-shaped plated tab wire formed with the peripheral portion of the copper foil being plated in an arc shape, or a flat plated tab wire formed with the peripheral portion of the copper foil being plated in a flat shape may be used.

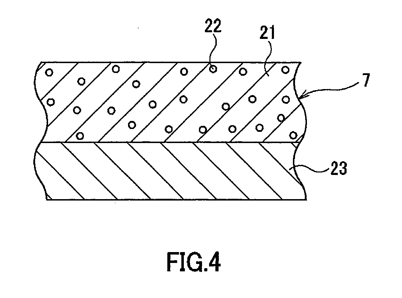

For example, as shown in Fig. 4, a conductive adhesive film 7 to form an adhesive agent layer for use in connecting the tab wires 6 with the basbar electrodes 4 and the rear surface electrode 5 is formed by allowing a thermosetting binder resin layer 21 to contain conductive particles 22 at a high density. Moreover, from the viewpoint of the push-in characteristic, the conductive adhesive film 7 preferably allows its binder resin to have the lowest melt viscosity in a range from 100 to 100000 Pa•s. When the lowest melt viscosity of the conductive adhesive film 7 is too low, the resin tends to flow from a temporarily press-bonding process to a main curing process to cause any connection failure or any protrusion onto the cell light receiving surface, resulting in a reduction in light receiving rate. Moreover, when the lowest melt viscosity is too high, a problem tends to occur upon pasting the film, sometimes, resulting in any adverse effect to connection reliability. Additionally, the lowest melt viscosity can be measured by loading a predetermined amount of a sample to a rotary viscometer and measuring the viscosity while raising the temperature at a predetermined rate.

Although not particularly limited, as the conductive particles 22 used for the conductive adhesive film 7, examples thereof include: metal particles such as nickel, gold, silver and copper, resin particles that are subjected to gold plating or the like, and those resin particles that are subjected to gold plating, with their outermost layer being coated with an insulating material. Moreover, by allowing flat flake-shaped metal particles to be contained as the conductive particles 22, the number of mutually overlapped conductive particles 22 is increased, making it possible to ensure good conduction reliability.

Moreover, the conductive adhesive film 7 preferably has a viscosity in a range from 10 to 10000 kPa•s, and more preferably, from 10 to 5000 kPa•s, near normal temperature. By setting the viscosity of the conductive adhesive film 7 in the range from 10 to 10000 kPa•s, it becomes possible to prevent so-called protrusion at the time when the conductive adhesive film 7 is wound into a reel shape as a tape, and also to maintain a predetermined tacking strength.

Although not particularly limited as long as the above-mentioned characteristics are not impaired, the composition of a binder resin layer 21 of the conductive adhesive film 7 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is approximately set to 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., a phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, any of these may be used. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present specification, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

As one example of a mode of the conductive adhesive film 7, as shown in Fig. 4, by forming a peeling base member 23 on one of the surfaces thereof, a film laminate body is formed, and this is molded and wound around into a tape shape. This tape-shaped conductive adhesive film 7 is wound around and staked into a reel body. As the peeling base member 23, not particularly limited, PET (Poly Ethylene Terephthalate), OPP (Oriented Polypropylene), PMP (Poly-4-methylpentene-1), PTFE (Polytetrafluoroethylene) and the like may be used. Moreover, the conductive adhesive film 7 may have a structure in which a transparent cover film is formed on a surface opposite to the surface on which the peeling base member 23 has been formed.

At this time, the tab wires 6 may be used as the cover film. By preliminarily stacking the tab wires 6 and the conductive adhesive film 7 as one integral laminate, the peeling base member 23 can be separated at the time of an actual application, and by pasting the conductive adhesive film 7 onto the busbar electrodes 4 and the rear surface electrode 5, the tab wires 6 can be connected to connection electrodes (the busbar electrodes 4, the rear surface electrode 5). Additionally, not limited to a reel body shape, the conductive adhesive film 7 may be formed into, for example, a strip shape.

In the case when the conductive adhesive film 7 is prepared as a reel body, by setting the viscosity of the conductive adhesive film 7 in a range from 10 to 10000 kPa•s, it becomes possible to prevent deformation of the conductive adhesive film 7, and consequently to maintain predetermined dimensions thereof. Moreover, in the case when the conductive adhesive tape 7 is formed into a stripe, with two or more of these being stacked, it is also possible to prevent deformation thereof and consequently to maintain predetermined dimensions thereof.

The conductive adhesive tape 7 can be formed by using, for example, the following method. First, the conductive particles 22, a film-forming resin forming the binder resin layer 21, a liquid-state epoxy resin, a potential curing agent and a silane coupling agent are dissolved in a solvent. As the solvent, toluene, ethyl acetate, or the like, or a mixed solvent of these may be used. Next, a resin-forming solution obtained by the dissolving process is applied onto the peeling base member 23, and the solvent is evaporated. Thus, the conductive adhesive film 7 is obtained.

### [First Sheet, Second Sheet]

A first sheet 10 and a second sheet 11 correspond to the first sealing resin layer and the second sealing resin layer. The first sheet 10 and the second sheet 11 are translucent sealing members made of, for example, ethylene vinyl acetate resin (EVA), urethane resin, or the like. The first sheet 10 and the second sheet 11 are interpolated between the matrix 9 and the surface cover 12 as well as between the matrix 9 and the back sheet 13 so that the surface cover 12 and the back sheet 13 are adhered to the matrix 9. Moreover, the first sheet 10 and the second sheet 11 cover the peripheral portion of the tab wire 6, and when the tab wire 6 is expanded/contracted by heat, absorb a stress caused by the expansion/contraction of the tab wire 6, thereby making it possible to prevent peeling of the tab wire 6 and cracks from occurring in the solar cell 2.

### [Surface Cover, Back Sheet]

As the surface cover 12, for example, a translucent material, such as glass, a translucent plastic material, or the like, is used. Moreover, as the back sheet 13, a laminate or the like, in which glass or an aluminum foil is sandwiched by resin films, is used.

The solar cell module 1 having the above-mentioned structure is produced by using, as described above, the tab wire 6 having a thickness (A) of 0.2 mm to 0.4 mm, and the first sheet 10 and the second sheet 11, each sheet having a thickness (B) that provides a ratio of thicknesses (B/A) relative to the thickness (A) of the tab wire 6 in a range from 1.4 to 3.0; therefore, it is possible to make a portion of the resin forming the first sheet 10 and the second sheet 11 hardly protrude from the peripheral portion of the surface cover 12 and the back sheet 13. Moreover, since the solar cell module 1 has the structure in which the ratio (B/A) of the tab wire 6 relative to the thickness (B) of each of the first sheet 10 and the second sheet 11 is set to 1.4 or more, no bubbles remain in the first sheet 10 and the second sheet 11. Furthermore, in the solar cell module 1, even when the tab wire 6 is expanded/ contracted due to heat, a stress caused by the expansion/contraction is absorbed by the first sheet 10 and the second sheet 11 so that it becomes possible to prevent peeling from occurring in the tab wire 6 and also to prevent cracks from occurring in the solar cell 2, thereby making it possible to prevent a reduction of the power generation efficiency.

### [Second Embodiment]

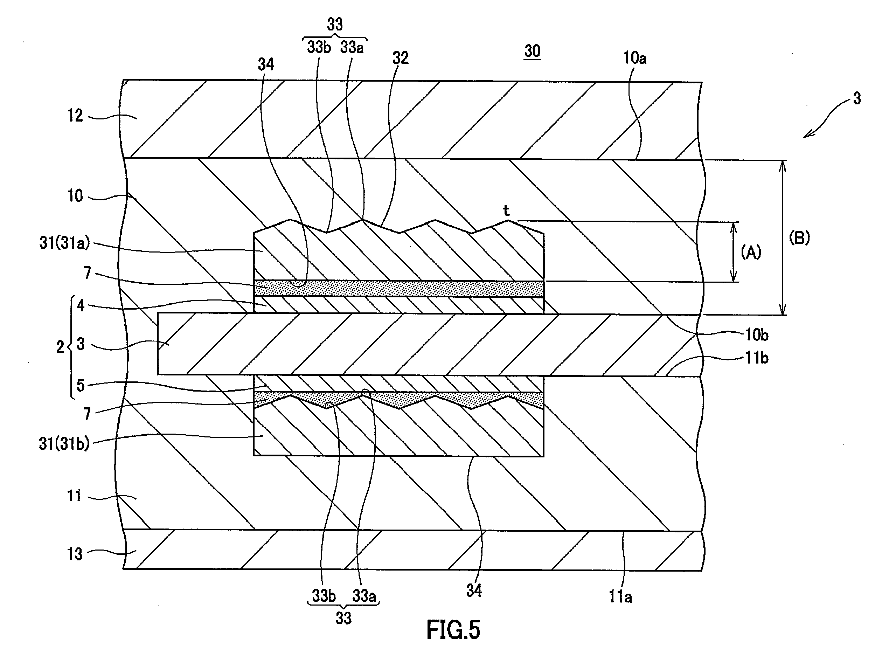

Although the above-mentioned solar cell module 1 has used the tab wire 6 having a flat surface, a solar cell module 30 shown in Fig. 5 uses a tab wire 31 having a convexo-concave portion 33 formed on one of the surfaces 32 thereof. In the solar cell module 30 shown in Fig. 5, by using this tab wire 31, an incident light ray that is made incident on the convexo-concave portion 33 of the surface 32 of the tab wire 31 is scattered by the convexo-concave portion 33 so that the scattered light is reflected by the surface cover 12 of glass or the like, and made incident on the light receiving surface. With this structure, the solar cell module 30 is allowed to exert a high light emitting efficiency.

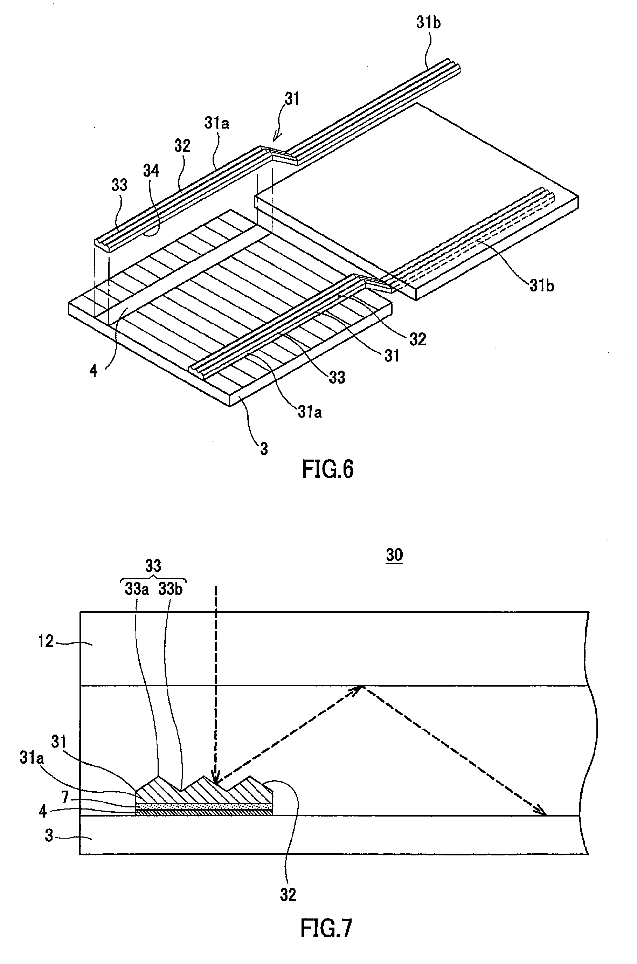

More specifically, as shown in Figs. 5 and 6, the tab wire 31 has the convexo-concave portion 33 formed on one of the surfaces 32, with the other surface 34 being formed into a flat surface.

Additionally, in the solar cell module 30, since the structure other than the tab wire 31 is the same as that of the solar cell module 1, the same members are indicated by the same reference numerals, and the detailed description thereof will be omitted.

More specifically, as shown in Fig. 5, on one of the surfaces 32 of the tab wire 31, a plurality of convex portions 33a and concave portions 33b that are continuous in the longitudinal direction are alternately formed in the width direction so that the convexo-concave portion 33 is formed. The convexo-concave portion 33 is formed, for example, by processes in which a ribbon-shaped copper foil that has been subjected to a plating process is press-molded.

As shown in Fig. 7, the solar cell module 30 has its one of the ends 31a connected to the busbar electrode 4. In the solar cell module 30, an incident light ray that has been made incident on the light-receiving surface side is scattered by the convexo-concave portion 33 so that the scattered light is reflected by the surface cover 12 and again made incident on the light-receiving surface. Thus, the solar cell 2 exerts a high light confinement effect, and can improve the light emitting efficiency.

Moreover, in the solar cell module 30, the surface convexo-concave portion 33 on the other end 31b of the tab wire 31 connected onto the rear surface electrode 5 formed on the rear surface side is also connected to the rear surface electrode 5 of the solar cell 2 via the conductive adhesive film 7, as shown in Fig. 5. In the solar cell module 30, the binder resin of the conductive adhesive film 7 is allowed to flow by heating and enter the concave portions 33b of the convexo-concave portion 33 of the tab wire 31 so that the connection reliability (adhesion strength) with the rear surface electrode 5 can be enhanced.

In the case when the tab wire 31 having the above-mentioned convexo-concave portion 33 is used, as shown in Fig. 5, the thickness (A) of the tab wire 31 refers to a distance from the top t of the convex portion 33a to the other surface 34 of the tab wire 31. The thickness (B) of the first sheet 10 refers to a distance from one of the surface 10a on the surface cover 12 side to the other surface 10b on the photoelectric conversion element 3 side. The thickness (B) of the second sheet 11 refers to a distance from one of the surfaces 11a on the back sheet 13 side to the other surface 11b on the photoelectric conversion element 3 side.

Upon producing the solar cell module 30, in the same manner as in the above-mentioned solar cell module 1, the surface cover 12 and the back sheet 13 are laminated with the first sheet 10 and the second sheet 11, each having such a thickness as to provide a ratio of thicknesses (B/A) of the thickness (A) of the tab wire 31 to the thickness (B) of each of the first sheet 10 and the second sheet 11 in a range from 1.4 to 3.0, being interpolated therebetween.

Therefore, in the same manner as in the aforementioned solar cell module 1, in this solar cell module 30, since the ratio of thicknesses (B/A) is set to 3.0 or less, it becomes possible to prevent one portion of the resin forming the first sheet 10 or the second sheet 11 from protruding onto the peripheral portion of the surface cover 12 and the back sheet 13 at the time of the laminating process. Since the solar cell module 30 has the ratio of thicknesses (B/A) that is 1.4 or more, it is possible to prevent bubbles from remaining in the first sheet 10 and the second sheet 11. Moreover, in the solar cell module 30, since the ratio of thicknesses (B/A) is set to 1.4 or more, even when the tab wire 31 is expanded/contracted due to heat, a stress caused by the expansion/contraction of the tab wire 31 is absorbed by the first sheet 10 and the second sheet 11 so that it becomes possible to prevent peeling from occurring on the tab wire 31 and also to prevent cracks from occurring in the solar cell 2, thereby making it possible to prevent a reduction of the power generation efficiency.

### [Third Embodiment]

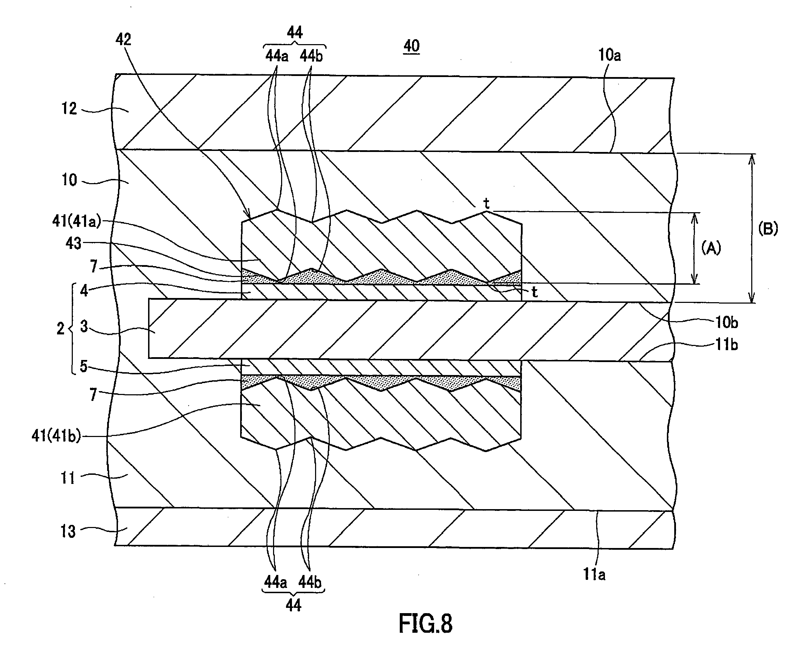

Although the above-mentioned solar cell module 30 has used the tab wire 31 having the convexo-concave portion 33 formed on one of the surfaces 32 on the light-receiving surface side, a solar cell module 40 shown in Fig. 8 uses a tab wire 41 having a convexo-concave portion 44 on one of the surfaces 42 of the tab wire 41 as well as on the other surface 43 thereof. In this solar cell module 40, in the same manner as in the solar cell module 30, an incident light ray is scattered by the convexo-concave portion 44 on the light-receiving surface side so that a high light emitting efficiency is achieved, and the binder resin of the conductive adhesive film 7 is allowed to enter the concave portions 44b so that the connection reliability (adhesion strength) between the tab wire 6 and the busbar electrodes 4 can be enhanced.

Moreover, in the solar cell module 40, in the same manner as in the aforementioned solar cell module 30, the binder resin of the conductive adhesive film 7 is allowed to enter the concave portions 44b on the rear surface side so that the connection reliability (adhesion strength) between the tab wire 6 and the rear electrode 5 can be enhanced.

Additionally, in the solar cell module 40, since the structure other than the tab wire 41 is the same as that of the solar cell module 1, the detailed description thereof will be omitted.

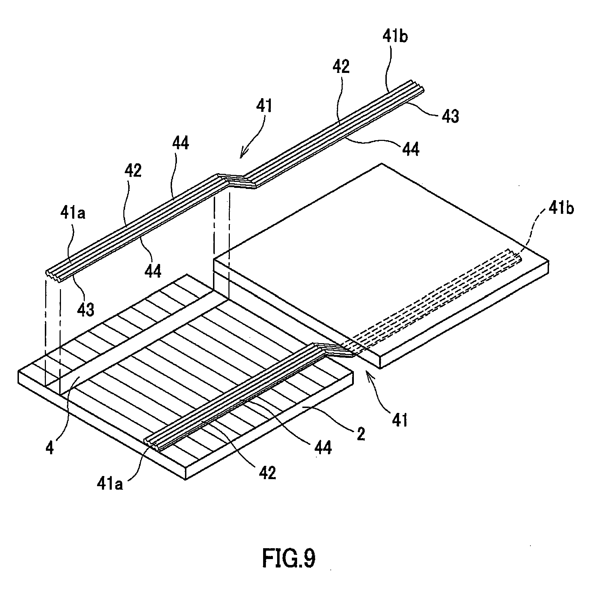

More specifically, as shown in Fig. 9, in the tab wire 41, the convexo-concave portions 44 are formed on one of the surfaces 42 and the other surface 43 respectively. The tab wire 41 has its one of the ends 4 1 a fixed onto the busbar electrode 4 of the solar cell 2 and connected thereto, with the other end 41b being fixed onto the rear surface electrode 5 of an adjacent solar cell 2 and connected thereto.

More specifically, as shown in Fig. 8, in the tab wire 41, since a plurality of convex portions 44a and concave portions 44b that are continuous in the longitudinal direction of the tab wire 41 are alternately formed in the width direction on both of one of the surfaces 42 and the other surface 43 so that the convexo-concave portions 44 are formed. Each of the convexo-concave portions 44 is formed, for example, by processes in which a ribbon-shaped copper foil that has been subjected to a plating process is press-molded.

In the case when the tab wire 41 having the above-mentioned convexo-concave portions 44 is used, as shown in Fig. 8, the thickness (A) of the tab wire 41 refers to a distance from the top t of the convex portion 44a to the top t of the convex portion 44a on the other surface 43. The thickness (B) of the first sheet 10 refers to a distance from one of the surface 10a on the surface cover 12 side to the other surface 10b on the photoelectric conversion element 3 side. The thickness (B) of the second sheet 11 refers to a distance from one of the surfaces 11a on the back sheet 13 side to the other surface 11b on the photoelectric conversion element 3 side.

Upon producing the solar cell module 40, in the same manner as in the aforementioned solar cell module 1, the surface cover 12 and the back sheet 13 are laminated with the first sheet 10 and the second sheet 11, each having such a thickness (B) as to provide a ratio of thicknesses (B/A) of the thickness (A) of the tab wire 41 to each of the first sheet 10 and the second sheet 11 in a range from 1.4 to 3.0, being interpolated therebetween.

Therefore, in this solar cell module 40, in the same manner as in the aforementioned solar cell module 1, since the ratio of thicknesses (B/A) is set to 3.0 or less, it becomes possible to prevent one portion of the resin forming the first sheet 10 or the second sheet 11 from protruding onto the peripheral portion of the surface cover 12 and the back sheet 13 at the time of the laminating process. Moreover, since the solar cell module 40 has the ratio of thicknesses (B/A) that is 1.4 or more, it is possible to prevent bubbles from remaining in the first sheet 10 and the second sheet 11. Furthermore, in the solar cell module 40 thus produced, since the ratio of thicknesses (B/A) is set to 1.4 or more, even when the tab wire 41 is expanded/contracted due to heat, a stress caused by the expansion/contraction of the tab wire 41 is absorbed by the first sheet 10 and the second sheet 11 so that it becomes possible to prevent peeling from occurring on the tab wire 41 and also to prevent cracks from occurring in the solar cell 2, thereby making it possible to prevent a reduction of the power generation efficiency.

Although the present invention has been described above by way of embodiments thereof, it is needless to say that the invention is not limited to the above embodiments, but that various changes may be made within the scope not departing from the gist of the invention.

In the above-mentioned first embodiment to third embodiments, by using the conductive adhesive film 7 as the adhesive agent layer, the respective busbar electrodes 4 and the rear surface electrode 5 are connected to the tab wires 6, 31 and 41; however, another adhesive agent layer may be used. In the case when a non-conductive adhesive film is used as the adhesive agent layer, the tab wires 6, 31 and 41 are directly made in contact with the busbar electrodes 4 and the rear surface electrode 5 respectively so as to provide conduction. Moreover, in place of providing the adhesive film, a paste-state adhesive agent, such as a conductive paste, a non-conductive paste, or the like, may be applied thereto with an appropriate thickness. By applying the conductive paste or the non-conductive paste with an appropriate thickness, functions and effects that are equivalent to those of the conductive adhesive film 7 and the non-conductive adhesive film can be obtained.

In the above-mentioned embodiments, explanations have been given by exemplifying solar cell modules 1, 30 and 40 provided with a one-surface light-receiving-type solar cell 2; however, not limited to this, a solar cell module provided with a two-surface light-receiving-type solar cell may be used. The two-surface light-receiving-type solar cell is provided with finger electrodes and busbar electrodes in place of the rear surface electrode 5. Moreover, the solar cell module provided with this solar cell is made to have a surface cover in place of the back sheet.

In this manner, in the solar cell module provided with the two-surface light-receiving-type solar cell as well, by using a tab wire having a thickness (A) in a range from 0.2 mm to 0.4 mm as each of the tab wires 6, 31 and 41, as well as by using a first sheet 10 and a second sheet 11 that set a ratio (B/A) relative to the thickness (B) of the first sheet 10 to form the first sealing resin layer and the second sheet 11 to form the second sealing resin layer in a range from 1.4 to 3.0 so as to carry out a sealing process, it becomes possible to prevent one portion of the first sheet 10 and the second sheet 11 from protruding from the peripheral portion of the surface covers attached to the two surfaces at the time of a laminating process, and also to prevent bubbles from remaining therein.

Moreover, in the solar cell module provided with the two-surface light-receiving- type solar cell, with respect to the tab wires 6, 31 and 41, a ratio (B/A) of a thickness (A) thereof and a thickness (B) of each of the first sheet 10 and the second sheet 11 is set to 1.4 to 3.0; therefore, even when each of the tab wires 6, 31 and 41 is expanded/contracted due to heat, a stress caused by the expansion/contraction of each of the tab wires 6, 31 and 41 is absorbed by the first sheet 10 and the second sheet 11 so that it becomes possible to prevent peeling from occurring in each of the tab wires 6, 31 and 41, and also to prevent cracks from occurring in the solar cell 2, thereby making it possible to prevent a reduction of the power generation efficiency.

### Examples

The following description will discuss specific examples of the present invention based upon the results of experiments actually carried out; however, the present invention is not intended to be limited by these examples.

### (Example 1)

In example 1, an uncured conductive adhesive film (trade name: SP 100 Series, made by Sony Chemical & Information Device Corporation) was temporarily pasted onto each of a busbar electrode and a rear surface electrode provided in a solar cell by carrying out a heating and compressing process at a heating temperature of 70°C and a pressure of 0.5 MPa for one second by the use of a temporarily pasting head. Next, onto each of the conductive adhesive film temporarily pasted onto the busbar electrode and conductive adhesive film temporarily pasted onto the rear surface electrode, a tab wire having flat surfaces on its two sides with a thickness of 0.20 mm was actually press-bonded. The actually press-bonding process was carried out under conditions of a heating temperature of 180°C and a pressure of 2 MPa for 15 seconds. Next, from the light-receiving surface side, a surface cover made of glass, a first sheet made of an ethylene vinyl acetate resin (EVA), the solar cell to which the tab wire was connected, a second sheet made of an ethylene vinyl acetate resin (EVA) and a back sheet were stacked in this order, and after having been evacuated into vacuum, a laminating process was carried out at 150°C for 3 minutes. Then, by heating this at 150°C for 30 minutes, the resin was completely hardened so that a solar cell module was produced.

In example 1, a solar cell of 6 inches was used, and the tab wire had a width that was virtually the same as the width of the busbar electrode and the rear surface electrode of the solar cell and a thickness (A) of 0.20 mm, and each of the first sheet and second sheet had a thickness (B) of 0.40 mm, with a ratio (B/A) of the thicknesses being set to 2.00.

### (Example 2 to Example 6)

In each of examples 2 to 6, the same processes as those of example 1 were carried out except that the thickness (A) of the tab wire, the thicknesses (B) of the first sheet and the second sheet and the ratio (B/A) of the thicknesses were set to those as shown in Table 1 so that a solar cell module was produced.

### (Example 7)

In example 7, the same processes as those of example 1 were carried out except that a tab wire with a convexo-concave portion formed on one of its surfaces, as shown in Fig. 5, was used, and that the thickness (A) of the tab wire, the thicknesses (B) of the first sheet and the second sheet and the ratio (B/A) of the thicknesses were set to those as shown in Table 1 so as to connect the convexo-concave portion with the rear surface electrode so that a solar cell module was produced.

### (Example 8)

In example 8, the same processes as those of example 1 were carried out except that a tab wire with convexo-concave portions formed on its two surfaces, as shown in Fig. 8, was used, and that the thickness (A) of the tab wire, the thicknesses (B) of the first sheet and the second sheet and the ratio (B/A) of the thicknesses were set to those as shown in Table 1 so as to connect the convexo-concave portions with the busbar electrodes and the rear surface electrode so that a solar cell module was produced.

### (Comparative Example 1 to Comparative Example 5)

In each of comparative examples 1 to 5, the same processes as those of example 1 were carried out except that the thickness (A) of the tab wire, the thicknesses (B) of the first sheet and the second sheet and the ratio (B/A) of the thicknesses were set to those shown in Table 2 so that a solar cell module was produced.

### (Comparative Examples 6, 7)

In each of comparative examples 6 and 7, the same processes as those of example 1 were carried out except that the tab wire was connected to the busbar electrode and the rear surface electrode by a solder plating process, and that the thickness (A) of the tab wire, the thicknesses (B) of the first sheet and the second sheet and the ratio (B/A) of the thicknesses were set to those shown in Table 2 so that a solar cell module was produced.

**[Table 1]**

| | Example 1 | Example 2 | Example 3 | Example 4 | Example 5 | Example 6 | Example 7 | Example 8 |
|---|---|---|---|---|---|---|---|---|
| TAB wire connection | Conductive adhesive film | Conductive adhesive film | Conductive adhesive film | Conductive adhesive film | Conductive adhesive film | Conductive adhesive film | Conductive adhesive film | Conductive adhesive film |
| Tab wire thickness (A) (mm) | 0.20 | 0.35 | 0.35 | 035 | 035 | 0.40 | 0.32 | 0.35 |
| Thickness (B) of first sheet and second sheet (mm) | 0.40 | 0.50 | 0.60 | 0.70 | 1.00 | 1.00 | 0.70 | 0.70 |
| B/A ratio | 2.00 | 1.43 | 1.71 | 2.00 | 2.86 | 2.50 | 2.19 | 2.00 |
| Laminating property (EVA protrusion/bubbles) | ⊚ | ⊚ | ⊚ | ⊚ | ○ | ○ | ⊚ | ⊚ |
| Power generation efficiency (initial) | ○ | ⊚ | ⊚ | ⊚ | ⊚ | ⊚ | ⊚ | ⊚ |
| Measured value | 16.06 | 16.475 | 16.492 | 16.492 | 16.452 | 16.58 | 16.61 | 16.65 |
| Reliability evaluation | ○ | Δ | ○ | ○ | ○ | ○ | ○ | ○ |
| Measured value | 15.777 | 15.8 | 16.45 | 16.47 | 16.44 | 16.3 | 16.59 | 16.64 |
| Output reduction rate | 1.76% | 4.10% | 0.25% | 0.13% | 0.07% | 1.69% | 0.15% | 0.10% |

**[Table 2]**

| | Comparative Example 1 | Comparative Example 2 | Comparative Example3 | Comparative Example 4 | Comparative Example 5 | Comparative Example 6 | Comparative Example 7 |
|---|---|---|---|---|---|---|---|
| TAB wire connection | Conductive adhesive film | Conductive adhesive film | Conductive adhesive film | Conductive adhesive film | Conductive adhesive film | Solder | Solder |
| Tab wire thickness (A) (mm) | 0.35 | 0.35 | 0.10 | 0.50 | 0.10 | 0.35 | 0.35 |
| Thickness (B) of first sheet and second sheet (mm) | 0.40 | 1.30 | 0.20 | 1.30 | 0.11 | 0.40 | 0.60 |
| B/A ratio | 1.14 | 3.71 | 2.00 | 2.60 | 1.10 | 1.14 | 1.71 |
| Laminating property (EVA protrusion/bubbles) | ⊚ | × | Δ | × | Δ | ⊚ | ⊚ |
| Power generation efficiency (initial) | ⊚ | ⊚ | × | × | × | Δ | Δ |
| Measured value | 16.509 | 16.4 | 15.5 | 13 | 15.5 | 15.9 | 15.8 |
| Reliability evaluation | × | - | - | - | - | × | × |
| Measured value | 12.878 | - | - | - | - | 10.5 | 12.9 |
| Output reduction rate | 21.99% | - | - | - | - | 33.96% | 18.35% |

### <Evaluation of Laminating Property>

The evaluation of a laminating property was carried out based upon the size of the largest portion of a portion protruded from the peripheral portion of the surface cover and the back sheet of the EVA resin forming the first sheet and the second sheet. In Table 1 and Table 2, when the largest protruded amount was in a range of 0 mm or more to 1.5 mm or less, this case was ranked as ⊚, when the protruded amount was in a range of 1.5 mm or more to 3.0 mm or less, this case was ranked as ○, and when the protruded amount was 3.0 mm or more, this case was ranked as x. Moreover, it was visually confirmed as to whether or not any bubbles remained in the first sheet and the second sheet, and when any bubbles remained, this case was ranked as Δ.

### <Evaluation of Power Generation Efficiency>

With respect to the evaluation of power generation efficiency, measurements were carried out on the power generation efficiency by using a solar simulator (Type: PVS1116i, made by Nisshinbo Mechatronics, Inc.) as a power generation efficiency measuring device, and the evaluation was conducted. The measuring conditions were set in compliance with JIS C8913 (Crystal-based solar cell output measuring method). In Table 1 and Table 2, when the initial power generation efficiency was 16.30% or more, this case was ranked as ⊚, when the initial power generation efficiency was in a range from 16.00% or more to 16.29% or less, this case was ranked as ○, when the initial power generation efficiency was in a range from 15.70% or more to 15.99% or less, this case was ranked as Δ, and when the initial power generation efficiency was 15.69% or less, this case was ranked as x.

### <Evaluation of Reliability>

Reliability was evaluated by carrying out a TC (Temperature Cycling) test. The test conditions were explained as follows: 200 cycles of cooling/heating cycles, each cycle consisting of exposures to atmospheres of -40°C and 85°C respectively for 30 minutes or more, were carried out, and the output was measured. Evaluation was carried out based upon a difference in outputs before and after the TC tests. In Table 1 and Table 2, when the output reduction was 2.0% or less, this case was ranked as ○, when the output reduction was in a range from 2.1 % or more to less than 5.0%, this case was ranked as Δ, and when the output reduction was 5.0% or more, this case was ranked as x.

From the results shown in Table 1 and Table 2, in examples 1 to 6, the thickness (A) of the tab wire was in a range from 0.2 to 0.4 mm, and since the ratio (B/A) of the thickness (A) of the tab wire to the thickness (B) of each sheet of the first sheet and the second sheet was 3.0 or less, it was possible to prevent one portion of the resin forming the first sheet 10 and the second sheet 11 from protruding onto the peripheral portion of the surface cover and the back sheet even at the time of a laminating process so that the protruded amount was less than 3.0 mm.

Moreover, in examples 1 to 6, since the ratio (B/A) of the thicknesses was 1.4 or more, no bubbles remained.

Furthermore, in examples 1 to 6, since the thickness of the tab wire was in a range from 0.2 to 0.4 mm, with the ratio (B/A) of the thicknesses being set in a range from 1.4 to 3.0, the tab wire itself had a low resistance value, and even when the tab wire was expanded/contracted by the TC test, a stress caused by the expansion/contraction of the tab wire could be absorbed by the first sheet and the second sheet. With this structure, in examples 1 to 6, since the connection between the tab wire and the busbar electrodes as well as the rear surface electrode was maintained and since no cracks occurred in the solar cell, the power generation efficiency was improved and a reduction of the output was suppressed.

In example 7 and example 8, although the convexo-concave portion was formed on the tab wire, since the ratio (B/A) of the thicknesses was set to 3.0 or less, in the same manner as in examples 1 to 6, it was possible to prevent one portion of the resin forming the first sheet and the second sheet from protruding onto the peripheral portion of the surface cover and the back sheet even at the time of a laminating process so that the protruded amount was less than 1.5 mm.

In examples 7 and 8 as well, since the ratio (B/A) of the thicknesses was set to 1.4 or more, no bubbles remained. In examples 7 and 8, since the ratio (B/A) of the thicknesses was 1.4 or more, a stress caused by the expansion/contraction of the tab wire could be absorbed by the first sheet and the second sheet, in the same manner as in examples 1 to 6, and since the connection between the tab wire and the busbar electrodes as well as the rear surface electrode was maintained and since no cracks occurred in the solar cell, the power generation efficiency was improved and a reduction of the output was suppressed.

Among examples, in examples 1, 3 and 4, since the ratio (B/A) of the thicknesses was in a range from 1.7 to 2.0, evaluation results that were superior to the other examples were obtained in all the laminating property, power generation efficiency and reliability evaluation.

In comparison with these examples, in comparative example 1, the ratio (B/A) of the thicknesses was 1.14, and since the thicknesses of the first sheet and the second sheet was thinner relative to the thickness of the tab wire, it was not possible for the first sheet and the second sheet to absorb a stress caused by the expansion/contraction of the tab wire at the time of the TC tests, resulting in peeling in the tab wire and cracks in the solar cell, with the result that the output in the TC tests was greatly lowered.

In comparative example 2, since the thickness (B) of the first sheet and the second sheet was thick, with the ratio (B/A) of the thicknesses being set to 3.71, which was greater than 3.0, one portion of the resin forming the first sheet and the second sheet protruded greatly from the peripheral portion of the surface cover and the back sheet at the time of a laminating process. For this reason, in comparative example 2, no reliability evaluation was carried out. Moreover, in the case when the first sheet and the second sheet are made thicker (1.0 mm or more) as in the case of comparative example 2, since material costs increase, this structure is not applicable from the viewpoint of practical use.

In comparative example 3, the ratio (B/A) of the thicknesses was 2.00, which was within the range of 1.4 to 3.0; however, since the thickness (A) of the tab wire was as thin as 0.10 mm, the resistance value of the tab wire itself became higher, resulting in a bad power generation efficiency. Moreover, in comparative example 3, since the thickness (B) of the first sheet and the second sheet was as thin as 0.20 mm, bubbles remained in the first sheet and the second sheet, resulting in a reduction in power generation efficiency. For this reason, in comparative example 3, no reliability evaluation was carried out.

In comparative example 4, the ratio (B/A) of the thicknesses was 2.60, which was within the range of 1.4 to 3.0; however, since the thickness (A) of the tab wire was as thick as 0.50 mm, the stress of the tab wire became higher to cause cracks in the solar cell, and the subsequent reduction in the initial power generation efficiency. Moreover, in comparative example 4, since the thickness (B) of the first sheet and the second sheet was as thick as 1.30 mm, a portion of the resin forming the first sheet and the second sheet greatly protruded at the time of a laminating process.

In comparative example 5, the thickness (A) of the tab wire was as thin as 0.10 mm, with the ratio (B/A) of the thicknesses being set to 1.10, which failed to satisfy the range of 1.4 to 3.0; consequently, the resistance value of the tab wire itself became higher, and since the thickness (B) of the first sheet and the second sheet was as thin as 0.11 mm, bubbles remained in the first sheet and the second sheet, resulting in a reduction in power generation efficiency.

In comparative examples 6 and 7, since the tab wire was connected to the busbar electrodes and the rear surface electrode by using a soldering process at a high temperature, the tab wire was separated from the electrodes due to a stress caused by the expansion/contraction of the tab wire due to the high temperature of the soldering process, and cracks occurred in the solar cell, with the result that the power generation efficiency and the output were lowered.

### Reference Signs List

1...solar cell module, 2...solar cell, 3...photoelectric conversion element, 4...busbar electrode, 5...rear surface electrode, 6...tab wire, 6a...one of ends, 6b...the other end, 7...conductive adhesive film, 8... string, 9...matrix, 10...first sheet, 11...second sheet, 12...surface cover, 13...back sheet, 14...metal frame, 17...finger electrode

## Claims

1. A method for producing a solar cell module comprising the steps of:
preparing a solar cell module having a plurality of solar cells, each provided with a surface electrode formed on a light-receiving surface side and a rear surface electrode formed on a rear surface on a side opposite to the light-receiving surface, the plural solar cells being connected to one after another with tab wires, each connected to the surface electrode of one of the solar cells and the rear surface electrode of another solar cell that is adjacent to the one of the solar cells with an adhesive agent layer being interpolated therebetween, so that the plural solar cells electrically connected to one another by the tab wires are sealed by a surface protective member on the light-receiving surface side and a rear surface protective member on the rear surface side, with a first sealing resin layer formed on the light-receiving surface side and a second sealing resin layer formed on the rear surface side being respectively interpolated therebetween,
disposing the tab wires each having a thickness in a range from 0.2 mm to 0.4 mm on the surface electrode and the rear surface electrode of the solar cell with the adhesive agent layer being interpolated therebetween,
by thermally press-bonding the tab wire on the adhesive agent layer so that the surface electrode and the rear surface electrode are connected to the tab wire; and
sealing the plural solar cells with the surface protective member and the rear surface protective member, with the first sealing resin layer and the second sealing resin layer being respectively interpolated therebetween, such that a ratio (B/A) of a thickness (A) of the tab wire to a thickness (B) of each of the layers of the first sealing resin layer and the second sealing resin layer is set in a range from 1.4 to 3.0.

2. The method for producing a solar cell module according to claim 1, wherein the adhesive agent layer is a conductive adhesive film containing conductive particles or a non-conductive adhesive film containing no conductive particles.

3. The method for producing a solar cell module according to claim 1 or 2, wherein the first sealing resin layer and the second sealing resin layer are made of an ethylene vinyl acetate resin.

4. The method for producing a solar cell module according to claim 1, wherein the ratio (B/A) of a thickness (A) of the tab wire to a thickness (B) of each of the layers of the first sealing resin layer and the second sealing resin layer is set in a range from 1.7 to 2.0.

5. The method for producing a solar cell module according to claim 1, wherein on two surfaces or one of the surfaces of the tab wire, convex portions and concave portions that are continuous in a longitudinal direction are alternately formed in a width direction.

6. A solar cell module comprising:
a plurality of solar cells, each provided with a surface electrode formed on a light-receiving surface side and a rear surface electrode formed on a rear surface on a side opposite to the light-receiving surface;
tab wires each of which electrically connects the surface electrode of one of the solar cells to the rear surface electrode of another solar cell that is adjacent to the one of the solar cells;
an adhesive agent layer that connects the surface electrode and the rear surface electrode with the tab wire;
a first sealing resin layer formed on the light-receiving surface side and a second sealing resin layer formed on the rear surface side that seal the plural solar cells that are electrically connected to one after another with the tab wires; and
a surface protective member and a rear surface protective member respectively formed outside the first sealing resin layer and the second sealing resin layer so as to protect the solar cells,
wherein each of the tab wires has a thickness (A) in a range from 0.2 mm to 0.4 mm; and a ratio (B/A) of the thickness (A) of the tab wire to a thickness (B) of each of the layers of the first sealing resin layer and the second sealing resin layer is set in a range from 1.4 to 3.0.

7. The solar cell module according to claim 6, wherein the adhesive agent layer is a conductive adhesive film containing conductive particles or a non-conductive adhesive film containing no conductive particles.

8. The solar cell module according to claim 6 or 7, wherein the first sealing resin layer and the second sealing resin layer are made of an ethylene vinyl acetate resin.

9. The solar cell module according to claim 6, wherein the ratio (B/A) of a thickness (A) of the tab wire to a thickness (B) of each of the layers of the first sealing resin layer and the second sealing resin layer is set in a range from 1.7 to 2.0.

10. The solar cell module according to claim 6, wherein on two surfaces or one of the surfaces of the tab wire, convex portions and concave portions that are continuous in a longitudinal direction are alternately formed in a width direction.
